# EUROPÄISCHE PATENTANMELDUNG

(11) **EP 1 189 343 A1**
(43) Veröffentlichungstag der Anmeldung: **20.03.2002**
(21) Anmeldenummer: 00120486.6
(22) Anmeldetag: 19.09.2000
(51) Int. Cl.: H03G 3/32

(54) **Adaptive Frequenzgangkorrektur akustischer Wiedergabeeinrichtungen**

(71) Anmelder: SIEMENS AKTIENGESELLSCHAFT, 80333 München (DE)
(72) Erfinder: Krueger, Werner, 81477 München (DE)

(57) **Zusammenfassung**

Die vorliegende Erfindung betrifft ein Verfahren und eine Vorrichtung zur Frequenzgangkorrektur akustischer Wiedergabeeinrichtungen. Bei dem erfindungsgemäßen Verfahren wird frequenzabhängig der Pegel des Nutzsignals angehoben um den Wert, um den das Hintergrundgeräusch (2) einen bestimmten Pegel überschreitet.

## Beschreibung

Die vorliegende Erfindung betrifft ein Verfahren zur automatischen Anpassung des Frequenzgangs einer akustischen Wiedergabeeinrichtung in Abhängigkeit vom Frequenzspektrum des Hintergrundgeräusches in der Umgebung der akustischen Wiedergabeeinrichtung.

Bekannt ist, den Frequenzgang einer akustischen Wiedergabeeinrichtung manuell einzustellen. Eine Möglichkeit hierzu ist, einen Testton auf die akustische Wiedergabeeinrichtung zu schalten. Mittels einer manuellen Regelung für die Verstärkung und somit des Signalpegels in den einzelnen Frequenzbereichen kann der Frequenzgang nun so angepaßt werden, daß der Testton keine Verzerrungen durch Reflexion und Absorption des Schalls in der Umgebung aufweist. Nachteilig ist, daß die Anpassung nur für definierte Bedingungen geeignet ist. Die Anpassung erfolgt zum Beispiel bei einer Verstärkeranlage in einem Konzertraum noch ohne Publikum und kann daher sich verändernde Absorbtions- und Reflexionsbedingungen sowie Hintergrundgeräusche prinzipiell nicht berücksichtigen.

Gerade in Stadien, Theatern, öffentlichen Verkehrsmitteln, Bahnhöfen etc. ändern sich jedoch sowohl die Hintergrundgeräusche, als auch die akustischen Gegebenheiten der Umgebung ständig, so daß gerade Sprache durch den dann nicht angepaßten Frequenzgang unverständlich wird und verzerrt klingt. Weiter ist bekannt, das zuvor beschriebene Verfahren zu automatisieren, indem mit einem Mikrofon der Testton erneut aufgenommen wird und durch eine Auswerteelektronik die Anpassung des Frequenzgangs automatisch erfolgt. Nachteilig ist, daß diese Anpassung nicht gleichzeitig mit der Wiedergabe des gewollten Signals über die akustische Wiedergabevorrichtung stattfinden kann, sondern einen gesonderten Testlauf erfordert. Allen bekannten Verfahren ist gemeinsam, daß immer nur der Einfluß der passiven akustischen Umgebung auf das wiederzugebende Signal korrigiert wird und nicht der Einfluß akustischer Emissionen im Bereich der Wiedergabeeinrichtung.

Insbesondere ist bei Telefon-Freisprecheinrichtungen in Kraftfahrzeugen das Sprechsignal von sich sehr schnell ändernden Hintergrundgeräuschen, z. B. Verkehrslärm Motor-, Reifen- und Fahrgeräuschen überlagert. Hier ist eine Anpassung des Frequenzgangs mit den bekannten Verfahren nicht ausreichend. Akustische Emissionen, die sich außerdem kontinuierlich verändern , werden dem Stand der Technik nach nicht berücksichtigt.

Der Erfindung liegt daher die Aufgabe zugrunde, ein Verfahren zur Verfügung zu stellen, mit dem eine automatische Anpassung des Frequenzgangs einer akustischen Wiedergabeeinrichtung in Abhängigkeit vom Hintergundgeräusch in der Umgebung der Wiedergabeeinrichtung möglich ist.

Diese Aufgabe wird erfindungsgemäß durch die Merkmale des Anspruchs 1 gelöst.

Bei dem erfindungsgemäßen Verfahren wird das Frequenzspektrum des Hintergrundgeräusches ermittelt. Sodann wird der Pegel des Nutzsignals in den Frequenzbereichen, in denen der Pegel des Hintergrundgeräusches einen vorgegebenen Pegel überschreitet, um den Betrag, um den der Pegel des Hintergrundgeräusches über dem vorgegebenen Pegel liegt, angehoben. Diese Schritte werden periodisch wiederholt.

Dadurch wird das Nutzsignal nur in den Frequenzbereichen verstärkt, in denen ein störendes Hintergrundgeräusch über einer bestimmten, sinnvoll zu wählenden, Mindestlautstärke vorhanden ist. Insbesondere kommt es nicht durch eine allgemein größere Lautstärke zu nachteiligen akustischen Erscheinungen wie z. B. Übersteuerung der Lautsprecher, da das Nutzsignal nicht insgesamt gleichmäßig angehoben wird, sondern nur die sonst vom Hintergrundgeräusch überlagerten Frequenzbereiche des Nutzsignals zusätzlich verstärkt werden. Es wird daher im Vergleich zu einer linearen Anhebung des Signals über den gesamten Frequenzbereich eine Verbesserung der Verständlichkeit erreicht.

Weiter ist es vorteilhaft bei obengenanntem Verfahren das Frequenzspektrum der Hintergrundgeräusche mittels digitaler Signalverarbeitung zu ermitteln und ebenso die Anhebung des Pegels des Nutzsignals durchzuführen.

In vielen Situationen, bei denen ein Einsatz des zuvor beschriebenen Verfahrens sinnvoll ist, wie Beschallung öffentlicher Gebäude und Plätze, aber auch Beschallung in Räumen, die typischerweise starke Hintergrundgeräusche haben, wie Fahrzeuge, erfolgt die Signalverarbeitung, aber auch eine eventuelle Signalkompression (Dynamik-Kompression), mit Hilfe der Methoden der digitalen Siganlverarbeitung. Dann ist ohne weitere Hardware allein durch Berücksichtigung in der Software die Anwendung des zuvor beschriebenen Verfahrens möglich. Das Verfahren ist daher kostengünstig zu realisieren. Dies gilt insbesondere dann,wenn, wie z.B. bei einem Mobiltelefon ein digitaler Signalprozessor ohnehin Bestandteil der Wiedergabeeinrichtung ist, da dann kein zusätzlicher Aufwand für die Hardware anfällt. Das erfindungsgemäße Verfahren eignet sich insbesondere für ein Autotelefon, da hier ständig wechselnde Hintergrundgeräusche vorliegen.

Nach einer weiteren Ausgestaltung der Erfindung wird der Pegelbereich, in dem sich der gegenüber dem Grundpegel korrigierte Pegel im Frequenzbereich der Störpegel ändern soll, limitiert. Dadurch können gewünschte oder erforderliche Dynamikverhältnisse des Gesamtsignals gewahrt bleiben.

Weiterhin ist erfindungsgemäß eine Vorrichtung, zur Durchführung der zuvor beschriebenen Verfahren vorgesehen, welche eine Filterschaltung zur Ermittlung des Frequenzspektrums des Hintergrundgeräusches umfaßt; sie weist ferner eine Auswerteschaltung auf, die in den Frequenzbereichen, in denen die Pegel des Hintergrundgeräusches einen vorgegebenen Pegel überschreiten, den Betrag, um den der Pegel des Hintergrundgeräusches über dem vorgegebenen Pegel liegt ermittelt.

Weiter enthält die Vorrichtung einen frequenzabhängig steuerbaren Verstärker, der den Pegel des Nutzsignals um den zuvor ermittelten Wert im entsprechenden Frequenzbereich des Hintergrundgeräusches anhebt.

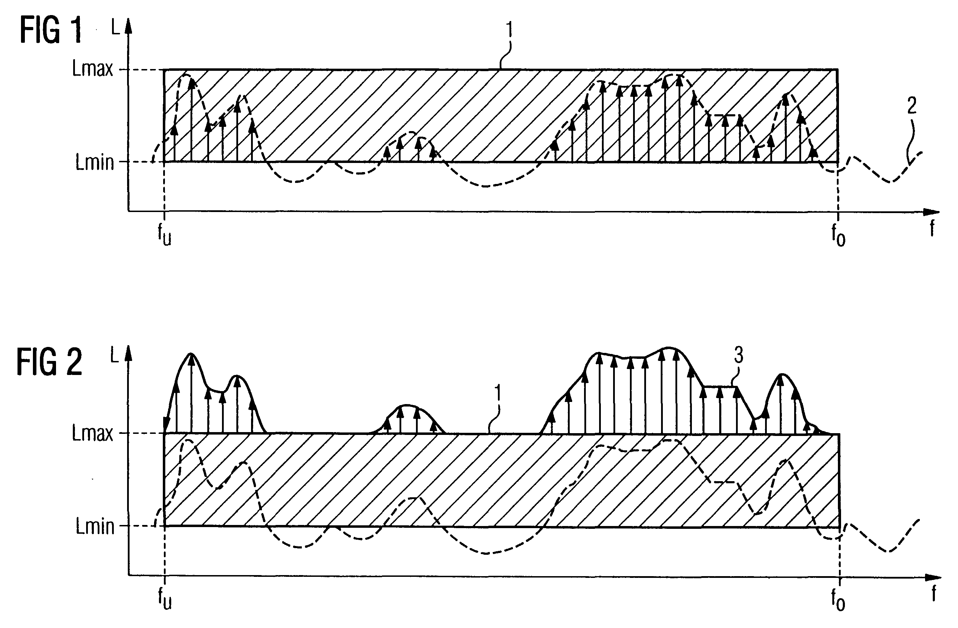

Die Erfindung wird folgend anhand der Figuren 1 und 2 erläutert.

Fig. 1 zeigt den Frequenzgang mit einem Hintergrundgeräusch.

Fig. 2 zeigt den frequenzabhängig angepaßten Frequenzgang.

Bezugnehmend auf Fig. 1 soll das Ermitteln des Frequenzspektrums der Hintergrundgeräusche erläutert werden. Der Frequenzgang einer akustischen Widergabeeinrichtung ist als Linie über der Frequenz darstellbar, wobei als Hochwert der Verstärkungsfaktor des verstärkten und wiedergegebenen Signals dient. Für die verschiedenen Werte der Verstärkung (je nach eingestellter Lautstärke) ergeben sich dann unterschiedliche Linien des Frequenzgangs. Bei einem idealen Verstärker, dessen Verstärkungsfaktor L in einem Frequenzbereich zwischen einer unteren Grenzfrequenz fᵤ und einer oberen Grenzfrequenz fₒ frequenzunabhängig ist, liegt die Verstärkerkennlinie horizontal in einem Bereich zwischen dem minimalen Verstärkungsfaktor Lₘᵢₙ und dem maximalen Verstärkungsfaktor Lₘₐₓ, also dem in Fig. 1 dargestellten rechteckigen Verstärkungsbereich 1. Dieser Verstärkungsbereich entspricht dem Pegelbereich des Nutzsignals. Ein Hintergrundgeräusch (2) mit frequenzabhängig unterschiedlichen Pegeln kann nun in diesen Bereich ragen. Soweit sein Pegel den Wert des Nutzsignalpegels für den Frequenzgang der geringsten Verstärkung überschreitet, wird die Pegeldifferenz für diese Frequenz ermittelt.

In Fig. 2 ist dargestellt, wie der Frequenzgang angepaßt wird. Die Charakteristik des Verstärkers wird so geändert, daß der ursprüngliche Signalpegelbereich (1) linear um die ermittelten Pegeldifferenzen des Störsignals entsprechend deren in Abhängigkeit von der Frequenz angehoben wird auf einen korrigierten Nutzsignalpegelbereich. Dabei werden die einzelnen Frequenzganglinien zu den Verstärkungswerten entsprechend frequenzabhängig angehoben.

Vorteilhafterweise wird die Ermittlung des Frequenzspektrums und das Anheben der Frequenzganglinien mit den Methoden der digitalen Signalverarbeitung durchgeführt. So kann kostengünstig die vorhandene Hardware genutzt werden und es muß nur die Software erweitert werden. Auch kann, wenn das bei einem Telefon vorhandene Mikrofon genutzt wird, mit den Methoden der digitalen Signalverarbeitung das Hintergrundgeräusch innerhalb bestimmter Zeitfenster von dem Nutzsignal unterschieden werden.

## Patentansprüche

1. Verfahren zur automatischen Anpassung des Frequenzgangs einer akustischen Wiedergabeeinrichtung für ein Nutzsignal, mit den Schritten:
a.) Ermitteln des Frequenzspektrums des Hintergrundgeräusches (2).
b.) Anheben des Pegels des Nutzsignals in den Frequenzbereichen, in denen der Pegel des Hintergrundgeräusches (2) einen vorgegebenen Pegel überschreitet, um den Betrag, um den der Pegel des Hintergrundgeräusches über dem vorgegebenen Pegel liegt.
c.) periodisches Wiederholen der Schritte a und b.

2. Verfahren nach Anspruch 1
**dadurch gekennzeichnet,**
**daß** das Ermitteln des Frequenzspektrums der Hintergrundgeräusche und die Anhebung des Pegels des Nutzsignals mittels digitaler Signalverarbeitung erfolgt.

3. Verwendung der Verfahren nach den Anspüchen 1 und 2 in einem Telefon, insbesondere Autotelefon.

4. Vorrichtung zur Durchführung der Verfahren nach dem Anspruch 1, mit
- einer Filterschaltung zur Ermittlung des Frequenzspektrums des Hintergrundgeräusches.
- einer Auswerteschaltung, die in den Frequenzbereichen, in denen der Pegel des Hintergrundgeräusches einen vorgegebenen Pegel überschreitet, den Betrag, um den der Pegel des Hintergrundgeräusches über dem vorgegebenen Pegel liegt ermittelt.
- einem frequenzabhängig steuerbaren Verstärker, der den Pegel des Nutzsignals um den zuvor ermittelten Wert im entsprechenden Frequenzbereich anhebt.
